# EUROPÄISCHE PATENTSCHRIFT

(11) **EP 2 911 994 B1**
(45) Veröffentlichungstag und Bekanntmachung des Hinweises auf die Patenterteilung: **01.01.2020**
(21) Anmeldenummer: 13783245.7
(22) Anmeldetag: 16.09.2013
(51) Int. Cl.: C04B 35/111, C04B 35/119, C04B 37/02

(54) **ELEKTRISCHE ODER ELEKTRONISCHE SCHALTUNG ODER SCHALTUNGSMODULE, ENTHALTEND EIN METALL-KERAMIK-SUBSTRAT IN FORM EINER LEITERPLATTE, SOWIE VERFAHREN ZUR DEREN HERSTELLUNG**
ELECTRIC OR ELECTRONIC CIRCUIT OR CIRCUIT MODULE CONTAINING A METAL-CERAMIC SUBSTRATE IN THE SHAPE OF A CIRCUIT BOARD AND A METHOD FOR PRODUCING THE SAME
CIRCUIT OU MODULE DE CIRCUIT ÉLECTRIC OU ÉLECTRONIQUE CONTENANT UN SUBSTRAT MÉTAL-CÉRAMIQUE AYANT LA FORME D'UNE CARTE DE CIRCUIT IMPRIMÉ ET PROCÉDÉ POUR LA FABRICATION

(30) Priorität: 29.10.2012 DE 102012110322
(43) Veröffentlichungstag der Anmeldung: 02.09.2015
(73) Patentinhaber: Rogers Germany GmbH, 92676 Eschenbach (DE)
(72) Erfinder: SCHMIDT, Karsten, 92676 Eschenbach (DE); MEYER, Andreas, 93173 Wenzenbach (DE); LEGATH, Alexander, 95683 Ebnath (DE); SCHMIRLER, Martina, 91275 Michelfeld (DE)
(74) Vertreter: Müller Schupfner & Partner Patent- und Rechtsanwaltspartnerschaft mbB
(86) Internationale Anmeldenummer: PCT/DE2013/100329
(87) Internationale Veröffentlichungsnummer: WO 2014/067511

(56) Entgegenhaltungen:
- EP-A1- 2 415 728
- DE-A1-102012 012 620
- JP-A- 2007 269 524

## Beschreibung

Die Erfindung bezieht sich auf elektrische oder elektronische Schaltungen oder Schaltungsmodule, enthaltend ein Metall-Keramik-Substrat in Form einer Leiterplatte, sowie ein Verfahren zur deren Herstellung.

Metall-Keramik-Substrate in Form von Leiterplatten bestehend aus einer Isolierschicht aus Keramik, aus wenigstens einer mit einer der Oberflächenseiten der Isolierschicht aus Keramik verbundenen und zur Ausbildung von Leiterbahnen, Kontakten, Kontakt- oder Befestigungsbereichen strukturierten Metallisierung sind in verschiedensten Ausführungen bekannt.

Um die Schichtdicke der auf einer Keramikschicht aufgebrachten Metallisierungen zu reduzieren, ist eine Erhöhung der Wärmeleitfähigkeit der Keramikschicht wünschenswert. Hierzu ist beispielsweise aus der DE 10 2004 012 231 B4 bereits ein metallisiertes Keramik-Substrat bekannt, bei dem zur Erzielung einer hohen mechanischen Festigkeit und einer hohen Wärmeleitfähigkeit die Keramikschicht aus einem Keramikmaterial mit einem Zirkoniumdioxidanteil hergestellt ist. Das Keramikmaterial enthält neben Aluminiumoxid (Al₂O₃) Zirkoniumdioxid (ZrO₂) sowie Yttriumoxid (Y₂O₃) und/oder Calciumoxid (CaO), wobei Al₂O₃, ZrO₂ sowie Y₂O₃ und/oder CaO in der Keramikschicht bezogen auf das Gesamtgewicht dieser Schicht in folgenden Anteilen enthalten sind:
- Al₂O₃ zwischen 91 und 97,96 Gewichtsprozent;
- ZrO₂ zwischen 2 und 9 Gewichtsprozent und
- Y₂O₃ und/oder CaO zwischen 0,04 und 1 Gewichtsprozent

Die Wärmeleitfähigkeit einer derartigen Keramikschicht beträgt zwischen 20 und 23 W/mK bei Raumtemperatur. Wünschenswert ist eine jedoch eine weitere

Erhöhungen der Wärmeleitfähigkeit, und zwar unter Beibehaltung oder lediglich geringfügiger Verschlechterung der Biegebruchfestigkeit der Keramikschicht bzw. des metallisierten Keramik-Substrates.

Bekannt ist beispielsweise auch das sogenannte "DCB-Verfahren" ("Direct-Copper-Bonding") zum Verbinden von Metallschichten oder -blechen, vorzugsweise Kupferblechen oder -folien mit einander und/oder mit Keramik oder Keramikschichten, und zwar unter Verwendung von Metall- bzw. Kupferblechen oder Metall- bzw. Kupferfolien, die an ihren Oberflächenseiten eine Schicht oder einen Überzug ("Aufschmelzschicht") aus einer chemischen Verbindung aus dem Metall und einem reaktiven Gas, bevorzugt Sauerstoff aufweisen. Bei diesem beispielsweise in der US-PS 37 44 120 oder in der DE-PS 23 19 854 beschriebenen Verfahren bildet diese Schicht oder dieser Überzug ("Aufschmelzschicht") ein Eutektikum mit einer Schmelztemperatur unter der Schmelztemperatur des Metalls (z.B. Kupfers), so dass durch Auflegen der Metall- bzw. Kupferfolie auf die Keramik und durch Erhitzen sämtlicher Schichten diese miteinander verbunden werden können, und zwar durch Aufschmelzen des Metalls bzw. Kupfers im Wesentlichen nur im Bereich der Aufschmelzschicht bzw. Oxidschicht.

Ein derartiges DCB-Verfahren weist dann beispielsweise folgende Verfahrensschritte auf:
- Oxidieren einer Kupferfolie derart, dass sich eine gleichmäßige Kupferoxidschicht ergibt;
- Auflegen des Kupferfolie mit der gleichmäßige Kupferoxidschicht auf die Keramikschicht;
- Erhitzen des Verbundes auf eine Prozesstemperatur zwischen etwa 1025 bis 1083°C, beispielsweise auf ca. 1071°C;
- Abkühlen auf Raumtemperatur.

Aus der JP 2007 269 524 A ist ein Metall-Keramik-Substrat bekannt, das eine Keramikschicht aufweist, wobei die Keramikschicht 95 Gew.-% Al₂O₃, 4 Gew. -% ZrO₂ und 1 Gew.-% Y₂O₃ enthält. Die Keramikschicht hat eine dicke von 0,3 mm und die durschnittliche Korngröße beträgt 5 Mikrometer.

Aus der EP 2 415 728 A1 ist ein Metall-Keramik-Substrat bekannt, das eine Al₂O₃ - Keramikschicht aufweist, wobei die Keramikschicht bis zu 30 Gew. -% ZrO₂. Zirkonoxidkörner sind zu mindestens 08 % tetragonal ausgebildet.

Ferner ist aus den Druckschriften DE 22 13 115 und EP-A-153 618 das sogenannte Aktivlot-Verfahren zum Verbinden von Metallisierungen bildenden Metallschichten oder Metallfolien, insbesondere auch von Kupferschichten oder Kupferfolien mit einem Keramikmaterial bzw. einer Keramikschicht bekannt. Bei diesem Verfahren, welches speziell auch zum Herstellen von Metall-Keramik-Substraten verwendet wird, wird bei einer Temperatur zwischen ca. 800 - 1000°C eine Verbindung zwischen einer Metallfolie, beispielsweise Kupferfolie, und einem Keramiksubstrat, beispielsweise einer Aluminiumnitrid-Keramik, unter Verwendung eines Hartlots hergestellt, welches zusätzlich zu einer Hauptkomponente, wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch eine chemische Reaktion eine Verbindung zwischen dem Hartlot und der Keramik her, während die Verbindung zwischen dem Hartlot und dem Metall eine metallische Hartlöt-Verbindung ist.

Ausgehend von dem voranstehend genannten Stand der Technik liegt der Erfindung die Aufgabe zugrunde, ein Metall-Keramik-Substrat als auch ein zugehöriges Verfahren zu dessen Herstellung aufzuzeigen, welches ein Keramikmaterial mit einem Zirkoniumdioxidanteil mit einer verbesserten Wärmeleitfähigkeit aufweist. Die Aufgabe wird durch ein elektronische oder elektrische Schaltung oder Schaltungsmodul mit einem Metall-Keramik-Substrat bzw. ein Verfahren zu dessen Herstellung gemäß der Patentansprüche 1 bzw. 9 gelöst.

Der wesentliche Aspekt des erfindungsgemäßen Metall-Keramik-Substrates ist darin zu sehen, dass Aluminiumoxid, Zirkoniumdioxid sowie Yttriumoxid in der Keramikschicht bezogen auf dessen Gesamtgewicht in folgenden Anteilen enthalten sind: Zirkoniumdioxid zwischen 2 und 1 5 Gewichtsprozent; Yttriumoxid zwischen 0,01 und 1 Gewichtsprozent und Aluminiumoxid zwischen 84 und 97 Gewichtsprozent, wobei die durchschnittliche Korngröße des verwendeten Aluminiumoxid zwischen 2 und 8 Mikrometer beträgt und das Verhältnis aus der Länge der Korngrenzen der Aluminiumoxid Körner und der Gesamtlänge aller Korngrenzen größer als 0,6 ist. Aufgrund der erfindungsgemäßen Keramikschicht mit einem Zirkoniumdioxidanteil zwischen 2 und 15 Gewichtsprozent sowie unter Verwendung von Aluminiumoxid mit einer durchschnittlichen Korngröße zwischen 2 und 8 Mikrometer konnte eine Erhöhung der Wärmeleitfähigkeit um bis zu 10 Prozent erreicht werden. Erfindungsgemäß weist die Keramikschicht eine Wärmeleitfähigkeit größer als 25 W/mK auf. Dadurch besteht die Möglichkeit der Reduzierung der Schichtdicke der Metallisierung abhängig vom Anwendungsfall auf bis zu 0,05 mm.

In einer vorteilhaften Ausführungsvariante der Erfindung beträgt der Anteil an Zirkoniumdioxid zwischen 2 und 10 Gewichtsprozent, der Anteil an Yttriumoxid zwischen 0,01 und 1 Gewichtsprozent und der Anteil an Aluminiumoxid zwischen 89 und 97 Gewichtsprozent. Durch die Reduzierung des Zirkoniumdioxidanteils auf unter 10 Gewichtsprozent und vorzugsweise gleichzeitiger Erhöhung der Sintertemperatur konnte eine weitere merkliche Verbesserung der Wärmeleitfähigkeit festgestellt werden, wobei eine zu hohe Sintertemperatur zu einer Verminderung der Biegebruchfestigkeit führt.

In einer Weiterbildung der Erfindung weist die Keramikschicht eine Biege-BruchFestigkeit größer 500 MPa auf.

In einer vorteilhaften Ausführungsvariante der Erfindung weist das Zirkoniumdioxid in der kristallinen Phase eine größtenteils tetragonale Kristallstruktur auf, wobei der Anteil der tetragonalen Kristallstruktur an der gesamten Kristallstruktur des Zirkoniumdioxid größer als 80% ist. Die Erhöhung der tetragonalen Kristallstruktur der Kristallphasen und ein damit verbundenes Austreiben der Glasphasen aus der Keramik bewirkt ebenfalls eine Verbesserung der Wärmeleitfähigkeit.

In einer Weiterbildung der Erfindung ist das erfindungsgemäße Metall-Keramik-Substrat beispielsweise derart ausgebildet, dass die Keramikschicht eine Schichtdicke zwischen 0,1 mm und 1,0 mm, vorzugsweise zwischen 0,2 mm und 0,5 mm aufweist. Die Metallisierung weist erfindungsgemäß eine Schichtdicke zwischen 0,05 mm und 1,2 mm vorzugsweise zwischen 0,1 mm und 0,5 mm auf.

Die Metallisierung kann zur Ausbildung von Kontakt- oder Bondflächen strukturiert sein. Die Metallisierung kann durch eine Folie oder Schicht aus Kupfer oder einer Kupferlegierung und/oder aus Aluminium oder einer Aluminiumlegierung gebildet sein.

Ebenfalls ist Gegenstand der Erfindung ein Verfahren zum Herstellen elektrischer oder elektronischer Schaltungen oder Schaltungsmodule, enthaltend ein Metall-Keramik-Substrat in Form einer Leiterplatte. Das Metall-Keramik-Substrat umfasst zumindest eine Keramikschicht mit einer ersten und zweiten Oberflächenseite, bei der zumindest eine der Oberflächenseiten mit mindestens einer Metallisierung verbunden wird, wobei die Keramikschicht aus einem Keramikmaterial umfassend Aluminiumoxid, Zirkoniumdioxid sowie Yttriumoxid hergestellt wird. Erfindungsgemäß werden zur Herstellung der Keramikschicht folgende Anteile an Aluminiumoxid, Zirkoniumdioxid sowie Yttriumoxid bezogen auf das Gesamtgewicht der Keramikschicht verwendet: Zirkoniumdioxid zwischen 2 und 15 Gewichtsprozent; Yttriumoxid zwischen 0,01 und 1 Gewichtsprozent und Aluminiumoxid zwischen 84 und 97 Gewichtsprozent, wobei die durchschnittliche Korngröße des verwendeten Aluminiumoxides zwischen 2 und 8 Mikrometer beträgt und das Verhältnis aus der Länge der Korngrenzen der Aluminiumoxid Körner und der Gesamtlänge aller Korngrenzen größer als 0,6 gewählt wird.

Das erfindungsgemäße Verfahren ist beispielsweise derart weitergebildet, dass bei Ausbildung der zumindest einen Metallisierung in Form einer Folie oder Schicht aus Kupfer oder einer Kupferlegierung die Metallisierung mit Keramikschicht mit Hilfe eines "Direct-Copper-Bonding"-Verfahrens oder eines Aktivlötverfahrens oder durch Kleben unter Verwendung eines Kunststoffklebers oder eines als Kleber geeigneten Polymers, vorzugsweise unter Verwendung eines Klebers, der Carbon-Fasern, insbesondere Carbon-Nanofasern enthält, verbunden wird und/oder
dass bei Ausbildung der zumindest einen Metallisierung in Form einer Folie oder Schicht aus Aluminium oder einer Aluminiumlegierung die Metallisierung und die Keramikschicht durch ein "Direct-Aluminium-Bonding"-Verfahren ("DAB-Verfahren") oder durch Kleben unter Verwendung eines Kunststoffklebers oder eines als Kleber geeigneten Polymers, vorzugsweise unter Verwendung eines Klebers, der Carbon-Fasern, insbesondere Carbon-Nanofasern enthält, miteinander verbunden werden, wobei die vorgenannten Merkmale jeweils einzeln oder Kombination Verwendung finden können.

Weiterhin vorteilhaft wird zur Herstellung der Keramikschicht Zirkoniumdioxid verwendet, welches in der kristallinen Phase eine größtenteils tetragonale Kristallstruktur aufweist, wobei der Anteil der tetragonalen Kristallstruktur an der gesamten Kristallstruktur des Zirkoniumdioxides größer als 80 Prozent ist.

Die Ausdrucke "näherungsweise", "im Wesentlichen" oder "etwa" bedeuten im Sinne der Erfindung Abweichungen vom jeweils exakten Wert um +/- 10%, bevorzugt um +/- 5% und/oder Abweichungen in Form von für die Funktion unbedeutenden Änderungen.

Weiterbildungen, Vorteile und Anwendungsmöglichkeiten der Erfindung ergeben sich auch aus der nachfolgenden Beschreibung von Ausführungsbeispielen und aus den Figuren.

Die Erfindung wird im Folgenden anhand der Figuren an Ausführungsbeispielen näher erläutert. Es zeigen:
- Fig. 1: eine vereinfachte Schnittdarstellung durch ein erfindungsgemäßes Metall-Keramik-Substrat mit einer Metallisierung und
- Fig. 2: eine vereinfachte Schnittdarstellung durch ein erfindungsgemäßes Metall-Keramik-Substrat mit zwei Metallisierungen
- Fig. 3: eine vereinfachte Schnittdarstellung einer alternative Ausführungsform des Metall-Keramik-Substrat gemäß Figur 2 mit zwei Metallisierungen und
- Fig. 4: in einem Diagramm den Verlauf der Wärmeleitfähigkeit einer herkömmlichen Keramikschicht und der beim erfindungsgemäßen Metall-Keramik-Substrates verwendeten Keramikschicht mit unterschiedlichen Zirkonoxidanteilen über der Temperatur.

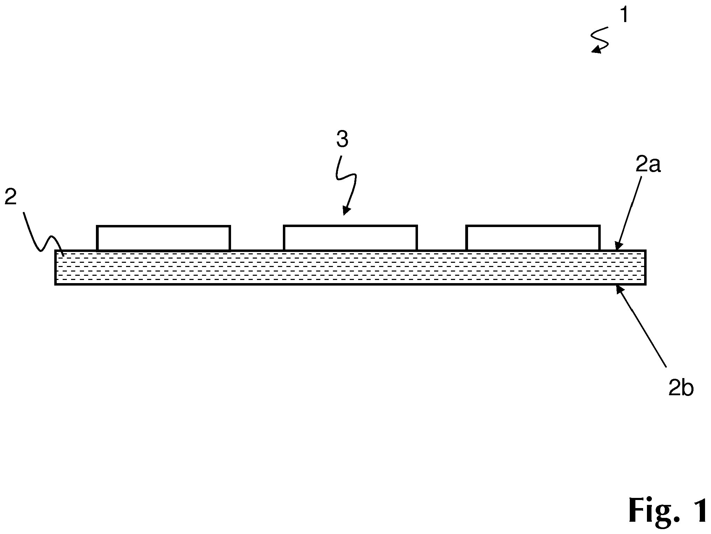

Figur 1 zeigt in vereinfachter Darstellung einen Schnitt durch ein erfindungsgemäßes Metall-Keramik-Substrat 1 umfassend zumindest eine Keramikschicht 2 mit zwei gegenüberliegenden Oberflächenseiten, und zwar einer ersten und zweiten Oberflächenseite 2a, 2b.

Das erfindungsgemäße Metall-Keramik-Substrat 1 gemäß Figur 1 ist mit mindestens einer Metallisierung 3 versehen. Im vorliegenden Ausführungsbeispiel ist die erste Oberflächenseite 2a mit einer ersten Metallisierung 3 und die der ersten Oberflächenseite 2a gegenüberliegende zweite Oberflächenseite 2b weist keine Metallisierung auf.

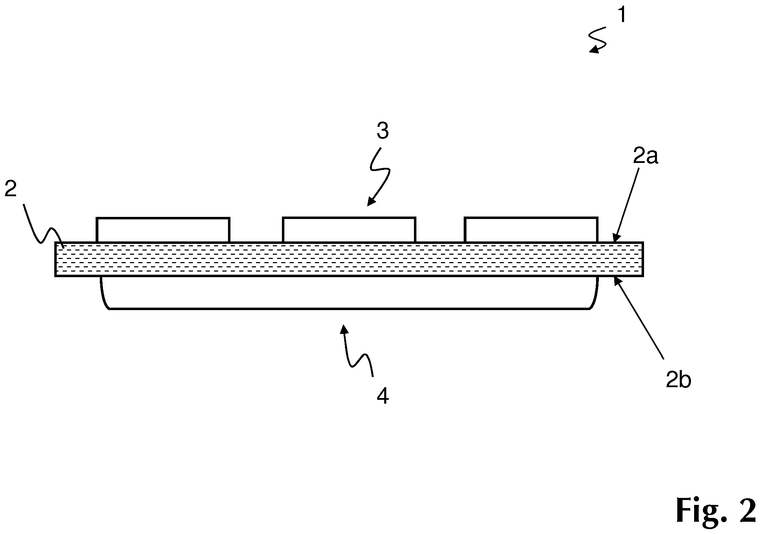

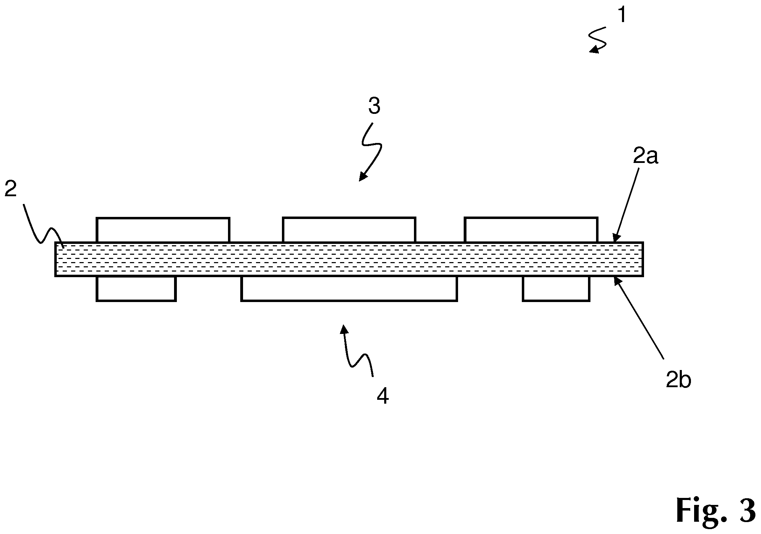

Figur 2 und Figur 3 zeigen zwei alternative Ausführungsvarianten eines erfindungsgemäße Metall-Keramik-Substrat 1, bei denen die erste Oberflächenseite 2a mit einer ersten Metallisierung 3 und die der ersten Oberflächenseite 2a gegenüberliegende zweite Oberflächenseite 2b mit einer zweiten Metallisierung 4 versehen ist.

Die erste und/oder zweite Metallisierungen 3, 4 sind vorzugsweise strukturiert ausgebildet, d.h. bildet mehrere Kontaktbereiche bzw. Kontaktflächen zum Anschluss von elektronischen Bauelementen aus. Figur 1 und 2 zeigen beispielhaft jeweils eine strukturierte erste Metallisierung 3 und Figur 3 eine strukturierte erste und zweite Metallisierung 3, 4.

Derartige Metall-Keramik-Substrate 1 dienen in bekannter Weise als erfindungsgemäße Leiterplatten für elektrische oder elektronische Schaltungen oder Schaltungsmodule, insbesondere für Leistungsschaltungen. Hierbei wird die Strukturierung der Metallisierungen 3, 4 mit den üblichen Techniken wie beispielsweise Maskierungs- und Ätztechnologien erstellt.

Erfindungsgemäß umfasst das zur Herstellung der Keramikschicht 2 des Metall-Keramik-Substrates 1 verwendete Keramikmaterial Aluminiumoxid (Al2O3), Zirkoniumdioxid (ZrÜ2) sowie Yttriumoxid (Y2O3). In der Keramikschicht 2 sind Aluminiumoxid, Zirkoniumdioxid sowie Yttriumoxid bezogen auf das das Gesamtgewicht der Keramikschicht 2 in folgenden Anteilen enthalten:
- Zirkoniumdioxid zwischen 2 und 15 Gewichtsprozent;
- Yttriumoxid zwischen 0,01 und 1 Gewichtsprozent und
- Aluminiumoxid zwischen 84 und 97 Gewichtsprozent.

Die durchschnittliche Korngröße des verwendeten Aluminiumoxides beträgt hierbei zwischen 2 und 8 Mikrometer. Eine noch verbesserte Wärmeleitfähigkeit ergibt sich insbesondere bei einer Zusammensetzung mit folgenden Anteilen:
- Zirkoniumdioxid zwischen 2 und 10 Gewichtsprozent;
- Yttriumoxid zwischen 0,01 und 1 Gewichtsprozent und
- Aluminiumoxid zwischen 89 und 97 Gewichtsprozent.

Die Keramikschicht 2 weist eine Kristallstruktur auf, d.h. besteht aus einer Vielzahl von Kristalliten bzw. Körnern, welche unmittelbar aneinander angrenzen. Kristalliten bzw. Körner unterschiedlicher Ausrichtung, jedoch ansonsten identischer Kristallstruktur sind mittels so genannter Korngrenzen voneinander getrennt. Ist das Verhältnis aus der Länge der Korngrenzen der Aluminiumoxid Körner und der Gesamtlänge der Korngrenzen der Körner aller Anteile größer als 0,6 gewählt, so ergibt sich eine deutliche Verbesserung der Wärmeleitfähigkeit. Auch wird hierdurch die Festigkeit der Keramikschicht 2 wesentlich erhöht. Die Wärmeleitfähigkeit der Keramikschicht 2 ist erfindungsgemäß größer als 25 W/mK, d.h. es ergibt sich im Vergleich zu bekannten Keramikschichten 2 mit einem ZirkoniumdioxidAnteil eine Erhöhung von 8 bis 10 Prozent.

Vorzugsweise weist das verwendete Zirkoniumdioxid in der kristallinen Phase eine größtenteils tetragonale Kristallstruktur auf, wobei der Anteil der tetragonalen Kristallstruktur an der gesamten Kristallstruktur des Zirkoniumdioxid größer als 80 Prozent ist.

Die Keramikschicht 2 weist ferner eine Schichtdicke zwischen 0,1 mm und 1,0 mm, vorzugsweise zwischen 0,2 mm und 0,5 mm auf, wobei die Biege-Bruch-Festigkeit der Keramikschicht 2 beispielsweise größer als 500 MPa gewählt ist.

Die Metallisierung 3, 4 sind beispielsweise durch eine Folie oder Schicht aus Kupfer oder einer Kupferlegierung und/oder aus Aluminium oder einer Aluminiumlegierung gebildet ist, d.h. es sind auch Kombinationen einer Kupfer bzw. Kupferlegierung und einer Aluminium bzw. Aluminiumlegierung denkbar. Hierbei beträgt die Schichtdicke der Metallisierung 3, 4 erfindungsgemäß zwischen 0,05 mm und 1,2 mm, vorzugsweise zwischen 0,1 mm und 0,5 mm.

Unter Berücksichtigung der für die Keramikschicht 2 und die Metallisierungen 3, 4 verwendeten Materialien eignen sich für das flächige Verbinden der Keramikschicht 2 mit der ersten bzw. zweiten Metallisierung 3, 4 unterschiedliche Verfahren.

So wird eine in Form einer Folie oder Schicht aus Kupfer oder einer Kupferlegierung gebildete Metallisierung 3, 4 beispielsweise durch Kleben unter Verwendung eines Kunststoffklebers oder eines als Kleber geeigneten Polymers, vorzugsweise unter Verwendung eines Klebers, der Carbon-Fasern, insbesondere Carbon-Nanofasern enthält, mit der Keramikschicht 2 verbunden. Alternativ kann die flächige Verbindung der Keramikschicht unter Verwendung des DCB-Verfahrens oder mit Hilfe des Aktivlötverfahrens erfolgen.

Eine aus Aluminium oder einer Aluminiumlegierung hergestellte Metallisierung 3, 4 wird beispielsweise durch ein "Direct-Aluminium-Bonding"-Verfahren ("DAB-Verfahren") oder durch Kleben unter Verwendung eines Kunststoffklebers oder eines als Kleber geeigneten Polymers, vorzugsweise unter Verwendung eines Klebers, der Carbon-Fasern, insbesondere Carbon-Nanofasern enthält, mit der Keramikschicht 2 verbunden.

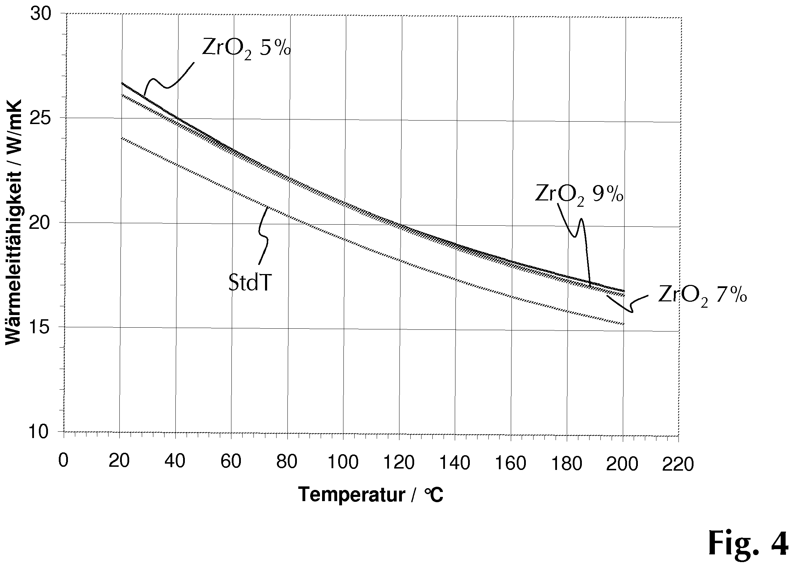

In Figur 4 ist beispielhaft in einem Diagramm der Verlauf der Wärmeleitfähigkeit in W/mK einer herkömmlichen Keramikschicht gemäß dem Stand der Technik und der beim erfindungsgemäßen Metall-Keramik-Substrates verwendeten Keramikschicht 2 mit unterschiedlichen Zirkonoxidanteilen, und zwar einer Keramikschicht mit einem ZrO₂-Anteil von 5%, einer Keramikschicht mit einem ZrO₂-Anteil von 7% und einer Keramikschicht mit einem ZrO₂-Anteil von 9% über der Temperatur in °C dargestellt. Daraus ist ersichtlich, dass die Wärmeleitfähigkeit bei Raumtemperatur von ca. 24 °C über 25 W/mK beträgt und sich somit eine Erhöhung der Wärmeleitfähigkeit um 8 - 10 % ergibt.

Die Erfindung wurde voranstehend an Ausführungsbeispielen beschrieben.

### Bezugszeichenliste

- 1: Metall-Keramik-Substrat
- 2: Keramikschicht
- 2a: erste Oberflächenseite
- 2b: zweite Oberflächenseite
- 3: erste Metallisierung
- 4: zweite Metallisierung

## Patentansprüche

1. Elektrische oder elektronische Schaltung oder Schaltungsmodule, enthaltend ein Metall-Keramik-Substrat in Form einer Leiterplatte, umfassend zumindest eine Keramikschicht (2) mit einer ersten und zweiten Oberflächenseite (2a, 2b), die an zumindest einer der Oberflächenseiten (2a, 2b) mit einer Metallisierung (3, 4) versehen ist, wobei das die Keramikschicht (2) bildende Keramikmaterial Aluminiumoxid, Zirkoniumdioxid sowie Yttriumoxid enthält, **dadurch gekennzeichnet, dass** Aluminiumoxid, Zirkoniumdioxid sowie Yttriumoxid in der Keramikschicht (2) bezogen auf dessen Gesamtgewicht in folgenden Anteilen enthalten sind:
Zirkoniumdioxid zwischen 2 und 15 Gewichtsprozent;
Yttriumoxid zwischen 0,01 und 1 Gewichtsprozent und
Aluminiumoxid zwischen 84 und 97 Gewichtsprozent,
wobei die durchschnittliche Korngröße des verwendeten Aluminiumoxides zwischen 2 und 8 Mikrometer beträgt und das Verhältnis aus der Länge der Korngrenzen der Aluminiumoxid Körner und der Gesamtlänge aller Korngrenzen größer als 0,6 ist, wobei die Keramikschicht (2) eine Wärmeleitfähigkeit größer als 25 W/mK aufweist, **dadurch gekennzeichnet, dass** die Metallisierung (3) eine Schichtdicke zwischen 0,05 mm und 1,2 mm aufweist.

2. Schaltung oder Schaltungsmodule nach Anspruch 1, **dadurch gekennzeichnet, dass** Aluminiumoxid, Zirkoniumdioxid sowie Yttriumoxid in der Keramikschicht (2) bezogen auf das dessen Gesamtgewicht in folgenden Anteilen enthalten sind:
Zirkoniumdioxid zwischen 2 und 10 Gewichtsprozent;
Yttriumoxid zwischen 0,01 und 1 Gewichtsprozent und
Aluminiumoxid zwischen 89 und 97 Gewichtsprozent beträgt.

3. Schaltung oder Schaltungsmodule nach einem der Ansprüche 1 oder 2, **dadurch gekennzeichnet, dass** die Keramikschicht (2) eine Biege-Bruch-Festigkeit größer 500 MPa aufweist.

4. Schaltung oder Schaltungsmodule nach einem der vorhergehenden Ansprüche, **dadurch gekennzeichnet, dass** die Keramikschicht (2) eine Schichtdicke zwischen 0,1 mm und 1,0 mm, vorzugsweise zwischen 0,2 mm und 0,5 mm aufweist.

5. Schaltung oder Schaltungsmodule nach einem der vorhergehenden Ansprüche, **dadurch gekennzeichnet, dass** Zirkoniumdioxid in der kristallinen Phase eine größtenteils tetragonale Kristallstruktur aufweist, wobei der Anteil der tetragonalen Kristallstruktur an der gesamten Kristallstruktur des Zirkoniumdioxid größer als 80 Prozent ist.

6. Schaltung oder Schaltungsmodule nach einem der vorhergehenden Ansprüche, **dadurch gekennzeichnet, dass** die Metallisierung (3) eine Schichtdicke zwischen 0,1 mm und 0,5 mm aufweist.

7. Schaltung oder Schaltungsmodule nach einem der vorhergehenden Ansprüche, **dadurch gekennzeichnet, dass** die Metallisierung (3) zur Ausbildung von Kontakt- oder Bondflächen strukturiert ist.

8. Schaltung oder Schaltungsmodule nach einem der vorhergehenden Ansprüche, **dadurch gekennzeichnet, dass** die Metallisierung (3, 4) durch eine Folie oder Schicht aus Kupfer oder einer Kupferlegierung und/oder aus Aluminium oder einer Aluminiumlegierung gebildet ist.

9. Verfahren zum Herstellen elektrischer oder elektronischer Schaltungen oder Schaltungsmodule, enthaltend ein Metall-Keramik-Substrat in Form einer Leiterplatte, umfassend zumindest eine Keramikschicht (2) mit einer ersten und zweiten Oberflächenseite (2a, 2b), bei der zumindest eine der Oberflächenseiten (2a, 2b) mit mindestens einer Metallisierung (4) flächig verbunden wird, wobei die Keramikschicht (2) aus einem Keramikmaterial umfassend Aluminiumoxid, Zirkoniumdioxid sowie Yttriumoxid hergestellt wird, **dadurch gekennzeichnet, dass** zur Herstellung der Keramikschicht (2) folgende Anteile an Aluminiumoxid, Zirkoniumdioxid sowie Yttriumoxid bezogen auf das Gesamtgewicht der Keramikschicht (2) verwendet werden:
Zirkoniumdioxid zwischen 2 und 1 5 Gewichtsprozent;
Yttriumoxid zwischen 0,01 und 1 Gewichtsprozent und
Aluminiumoxid zwischen 84 und 97 Gewichtsprozent,
wobei die durchschnittliche Korngröße des verwendeten Aluminiumoxides zwischen 2 und 8 Mikrometer beträgt und das Verhältnis aus der Länge der Korngrenzen der Aluminiumoxid Körner und der Gesamtlänge aller Korngrenzen größer als 0,6 gewählt wird, wobei die Keramikschicht (2) eine Wärmeleitfähigkeit größer als 25 W/mK aufweist, **dadurch gekennzeichnet, dass** die Metallisierung (3) eine Schichtdicke zwischen 0,05 mm und 1,2 mm aufweist.

10. Verfahren nach Anspruch 9, **dadurch gekennzeichnet, dass** bei Ausbildung der zumindest einen Metallisierung (3, 4) in Form einer Folie oder Schicht aus Kupfer oder einer Kupferlegierung die Metallisierung (3, 4) mit Keramikschicht (2) mit Hilfe eines "Direct-Copper-Bonding"-Verfahrens oder eines Aktivlötverfahrens oder durch Kleben unter Verwendung eines Kunststoffklebers oder eines als Kleber geeigneten Polymers, vorzugsweise unter Verwendung eines Klebers, der Carbon-Fasern, insbesondere Carbon- Nanofasern enthält, verbunden wird.

11. Verfahren nach einem der Ansprüche 9 oder 10 , **dadurch gekennzeichnet, dass** bei Ausbildung der zumindest eine Metallisierung (3, 4) in Form einer Folie oder Schicht aus Aluminium oder einer Aluminiumlegierung die Metallisierung (3, 4) und die Keramikschicht (2) durch ein "Direct-Aluminium-Bonding"-Verfahren ("DAB-Verfahren") oder durch Kleben unter Verwendung eines Kunststoffklebers oder eines als Kleber geeigneten Polymers, vorzugsweise unter Verwendung eines Klebers, der Carbon-Fasern, insbesondere Carbon-Nanofasern enthält, miteinander verbunden werden.

12. Verfahren nach einem der Ansprüche 9 bis 11, **dadurch gekennzeichnet, dass** zur Herstellung der Keramikschicht (2) Zirkoniumdioxid verwendet wird, welches in der kristallinen Phase eine größtenteils tetragonale Kristallstruktur aufweist, wobei der Anteil der tetragonalen Kristallstruktur an der gesamten Kristallstruktur des Zirkoniumdioxides größer als 80 Prozent ist.

## Claims

1. An electrical or electronic circuit or circuit modules including a metal-ceramic substrate in the form of a printed circuit board comprising at least one ceramic layer (2) having first and second surface sides (2a, 2b) being provided on at least one of said surface sides (2a, 2b) with a metallization (3, 4), the ceramic material forming the ceramic layer (2) including aluminium oxide, zirconium dioxide and yttrium oxide, **characterized in that** aluminium oxide, zirconium dioxide and yttrium oxide are included in the ceramic layer (2) in the following proportions, relative to the total weight thereof:
zirconium dioxide between 2 and 15 percent by weight;
yttrium oxide between 0.01 and 1 percent by weight and
aluminium oxide between 84 and 97 percent by weight,
wherein the averaged grain size of the aluminium oxide used is between 2 and 8 micrometers and the ratio of the length of the grain boundaries of the aluminium oxide grains and the total length of all grain boundaries is greater than 0.6, wherein the ceramic layer (2) has a thermal conductivity greater than 25 W/mK, **characterized in that** the metallization (3) has a layer thickness between 0.05 mm and 1.2 mm.

2. The circuit or circuit modules according to claim 1, **characterized in that** aluminium oxide, zirconium dioxide and yttrium oxide are included in the ceramic layer (2) in the following proportions relative to the total weight thereof:
zirconium dioxide between 2 and 10 percent by weight;
yttrium oxide between 0.01 and 1 percent by weight and
aluminium oxide is between 89 and 97 per cent by weight.

3. The circuit or circuit modules according to one of claims 1 or 2, **characterized in that** the ceramic layer (2) has a flexural strength greater than 500 MPa.

4. The circuit or circuit modules according to one of the preceding claims, **characterized in that** the ceramic layer (2) has a layer thickness between 0.1 mm and 1.0 mm, preferably between 0.2 mm and 0.5 mm.

5. The circuit or circuit modules according to one of the preceding claims, **characterized in that** zirconium dioxide in the crystalline phase has a mostly tetragonal crystal structure, the proportion of the tetragonal crystal structure in the total crystal structure of the zirconium dioxide being greater than 80 percent.

6. The circuit or circuit modules according to one of the preceding claims, **characterized in that** the metallization (3) has a layer thickness between 0.1 mm and 0.5 mm.

7. The circuit or circuit modules according to one of the preceding claims, **characterized in that** the metallization (3) is structured to form contact or bonding surfaces.

8. The circuit or circuit modules according to one of the preceding claims, **characterized in that** the metallization (3, 4) is formed by a foil or layer of copper or a copper alloy and/or of aluminium or an aluminium alloy.

9. A method for producing electrical or electronic circuits or circuit modules, including a metal-ceramic substrate in the form of a printed circuit board, comprising at least one ceramic layer (2) with a first and second surface side (2a, 2b), to at least one of the surface sides (2a, 2b) being flatly bonded to at least one metallization (4), the ceramic layer (2) being produced from a ceramic material comprising aluminium oxide, zirconium dioxide and yttrium oxide, **characterized in that** the following proportions of aluminium oxide, zirconium dioxide and yttrium oxide, relative to the total weight of the ceramic layer (2), are used to produce the ceramic layer (2):
zirconium dioxide between 2 and 1 5 percent by weight;
yttrium oxide between 0.01 and 1 percent by weight and
aluminium oxide between 84 and 97 percent by weight,
wherein the average grain size of the aluminium oxide used is between 2 and 8 micrometers and the ratio of the length of the grain boundaries of the aluminium oxide grains and the total length of all grain boundaries is selected to be greater than 0.6, wherein the ceramic layer (2) having a thermal conductivity greater than 25 W/mK, **characterized in that** the metallization (3) has a layer thickness between 0.05 mm and 1.2 mm.

10. The method according to claim 9, **characterized in that**, when at least one metallization (3, 4) is formed in the form of a foil or layer of copper or a copper alloy, the metallization (3, 4) is bonded to a ceramic layer (2) by means of a "direct copper bonding" process or an active soldering process or by bonding using a plastic adhesive or a polymer suitable as adhesive, preferably using an adhesive including carbon fibres, in particular carbon nanofibres.

11. The method according to one of claims 9 or 10, **characterized in that**, when at least one metallization (3, 4) in the form of a foil or layer of aluminium or an aluminium alloy is formed, the metallization (3, 4) and the ceramic layer (2) are bonded together by a "direct aluminium bonding" process ("DAB process") or by bonding using a plastic adhesive or a polymer suitable as adhesive, preferably using an adhesive including carbon fibres, in particular carbon nanofibres.

12. A method according to any one of claims 10 to 12, **characterized in that** zirconium dioxide is used to produce the ceramic layer (2), which in the crystalline phase has a mostly tetragonal crystal structure, wherein the proportion of the tetragonal crystal structure to the total crystal structure of the zirconium dioxide is greater than 80 percent.

## Revendications

1. Circuit ou module de circuit électrique ou électronique, contenant un substrat métal/céramique sous la forme d'une carte à circuits, incluant au moins une couche en céramique (2) avec un premier côté de surface et un second côté de surface (2a, 2b), qui est doté d'une métallisation (3, 4) sur l'un au moins des deux côtés de surface (2a, 2b), dans lequel la matière céramique formant la couche en céramique (2) contient de l'oxyde d'aluminium, du dioxyde de zirconium ainsi que de l'oxyde d'yttrium,
**caractérisé en ce que** l'oxyde d'aluminium, le dioxyde de zirconium ainsi que l'oxyde d'yttrium sont contenus dans la couche en céramique (2) dans les proportions suivantes, par référence à son poids total :
| | |
|---|---|
| dioxyde de zirconium | entre 2 et 15 % en poids ; |
| oxyde d'yttrium | entre 0,01 et 1 % en poids ; et |
| oxyde d'aluminium | entre 84 et 97 % en poids, |
dans lequel la granulométrie moyenne de l'oxyde d'aluminium utilisé est entre 2 et 8 µm, et le rapport de la longueur des limites des grains d'oxyde d'aluminium sur la longueur totale de toutes les limites de grains est supérieure à 0,6, dans lequel la couche en céramique (2) présente une conductibilité thermique supérieure à 25 W/mK,
**caractérisé en ce que** la métallisation (3) présente une épaisseur de couche entre 0,05 mm et 1,2 mm.

2. Circuit ou module de circuit selon la revendication 1, **caractérisé en ce que** l'oxyde d'aluminium, le dioxyde de zirconium ainsi que l'oxyde d'yttrium sont contenus dans la couche en céramique (2) dans les proportions suivantes, par référence à son point total :
| | |
|---|---|
| dioxyde de zirconium | entre 2 et 10 % en poids ; |
| oxyde d'yttrium | entre 0,01 et 1 % en poids ; et |
| oxyde d'aluminium | entre 89 et 97 % en poids. |

3. Circuit ou module de circuit selon l'une des revendications 1 ou 2,
**caractérisé en ce que** la couche en céramique (2) présente une résistance à la rupture en flexion supérieure à 500 MPa.

4. Circuit ou module de circuit selon l'une des revendications précédentes,
**caractérisé en ce que** la couche en céramique (2) présente une épaisseur de couche entre 0,1 mm et 1,0 mm, de préférence entre 0,2 mm et 0,5 mm.

5. Circuit ou module de circuit selon l'une des revendications précédentes,
**caractérisé en ce que** le dioxyde de zirconium présente dans la phase cristalline une structure cristalline majoritairement tétragonale, et la proportion de la structure cristalline tétragonale dans la structure cristalline totale du dioxyde de zirconium est supérieure à 80 %.

6. Circuit ou module de circuit selon l'une des revendications précédentes,
**caractérisé en ce que** la métallisation (3) présente une épaisseur de couche entre 0,1 mm et 0,5 mm.

7. Circuit ou module de circuit selon l'une des revendications précédentes,
**caractérisé en ce que** la métallisation (3) est structurée en vue de réaliser des surfaces de contact ou de bonding.

8. Circuit ou module de circuit selon l'une des revendications précédentes,
**caractérisé en ce que** la métallisation (3, 4) est formée par une feuille ou une couche de cuivre ou d'un alliage de cuivre et/ou d'aluminium ou d'un alliage d'aluminium.

9. Procédé pour la réalisation de circuits ou de modules de circuits électriques ou électroniques, contenant un substrat métal/céramique sous la forme d'une carte à circuits, incluant au moins une couche en céramique (2) avec un premier côté de surface et un second côté de surface (2a, 2b), dans lequel l'un au moins des côtés de surface (2a, 2b) est relié de façon surfacique à au moins une métallisation (4), dans lequel la couche en céramique (2) est réalisée à partir d'un matériau céramique incluant de l'oxyde d'aluminium, du dioxyde de zirconium ainsi que de l'oxyde d'yttrium,
**caractérisé en ce que**, pour la fabrication de la couche en céramique (2) on emploie les proportions suivantes d'oxyde d'aluminium, de dioxyde de zirconium et d'oxyde d'yttrium, par référence au poids total de la couche en céramique (2) :
| | |
|---|---|
| dioxyde de zirconium | entre 2 et 15 % en poids ; |
| oxyde d'yttrium | entre 0,01 et 1 % en poids ; et |
| oxyde d'aluminium | entre 84 et 97 % en poids, |
dans lequel la granulométrie moyenne de l'oxyde d'aluminium utilisé est entre 2 et 8 µm, et le rapport de la longueur des limites des grains de l'oxyde d'aluminium sur la longueur totale de toutes limites de grains est choisie supérieure à 0,6, et la couche en céramique (2) présente une conductibilité thermique supérieure à 25 W/mK,
**caractérisé en ce que** la métallisation (3) présente une épaisseur de couche entre 0,05 mm et 1,2 mm.

10. Procédé selon la revendication 9, **caractérisé en ce que** lors de la réalisation de ladite au moins une métallisation (3, 4) sous la forme d'une feuille ou d'une couche en cuivre ou en alliage de cuivre, la métallisation (3, 4) est reliée à la couche en céramique (2) à l'aide d'une procédure dite "direct copper bonding" (bonding direct sur cuivre), ou une procédure de brasage actif, ou encore par collage en utilisant une colle pour matière plastique ou un polymère approprié à titre de colle, de préférence en utilisant une colle qui contient des fibres de carbone, en particulier des nanofibres de carbone.

11. Procédé selon l'une des revendications 9 ou 10, **caractérisé en ce que** lors de la réalisation de ladite au moins une métallisation (3, 4) sous la forme d'une feuille ou d'une couche en aluminium ou un alliage d'aluminium, la métallisation (3, 4) et la couche en céramique (2) sont reliées l'une à l'autre par une procédure dite "direct aluminium bonding" (bonding direct sur aluminium), ou par collage en utilisant une colle pour matière plastique ou un polymère approprié à titre de colle, qui contient des fibres de carbone et en particulier des nanofibres de carbone.

12. Procédé selon l'une des revendications 10 et 11,
**caractérisé en ce que** pour la réalisation de la couche en céramique (2) on utilise du dioxyde de zirconium qui présente dans la phase cristalline une structure cristalline majoritairement tétragonale, et la proportion de la structure cristalline tétragonale dans la structure cristalline totale du dioxyde de zirconium est supérieure à 80 %.
